(19) Europäisches Patentamt
European Patent Office
Office européen des brevets

(11) EP 2 000 297 A1

(12) **EUROPEAN PATENT APPLICATION**
published in accordance with Art. 153(4) EPC

(43) Date of publication:
10.12.2008 Bulletin 2008/50

(51) Int Cl.:
*B32B 9/00* (2006.01)     *B65D 65/40* (2006.01)
*B65D 81/24* (2006.01)    *C23C 14/06* (2006.01)
*C23C 16/42* (2006.01)

(21) Application number: 07737585.5

(22) Date of filing: 01.03.2007

(86) International application number:
PCT/JP2007/053905

(87) International publication number:
WO 2007/111075 (04.10.2007 Gazette 2007/40)

(84) Designated Contracting States:
AT BE BG CH CY CZ DE DK EE ES FI FR GB GR
HU IE IS IT LI LT LU LV MC MT NL PL PT RO SE
SI SK TR

(30) Priority: 24.03.2006 JP 2006082436

(71) Applicant: Konica Minolta Medical & Graphic, Inc.
Hino-shi,
Tokyo 191-8511 (JP)

(72) Inventor: TAKEYAMA, Toshihisa
Tokyo 163-0512 (JP)

(74) Representative: Alton, Andrew
Urquhart-Dykes & Lord LLP
Tower North Central
Merrion Way
Leeds LS2 8PA (GB)

(54) **TRANSPARENT BARRIER SHEET AND METHOD FOR PRODUCING TRANSPARENT BARRIER SHEET**

(57)     Disclosed is a transparent barrier sheet **characterized by** comprising at least one transparent inorganic thin film layer and at least one transparent organic thin film layer on a base sheet on which a transparent primer layer is arranged. This transparent barrier sheet is also **characterized in that** the transparent inorganic thin film layer mainly contains silicon nitride or silicon nitride oxide, and the transparent organic thin film layer is formed by radically polymerizing a radically polymerizable compound or cationically polymerizing a cationically polymerizable compound. This transparent barrier sheet is further **characterized in that** the transparent primer layer has a surface roughness Ra of not more than 5 nm. This transparent barrier sheet is excellent in gas barrier property and bending resistance. Also disclosed is a method for producing such a transparent barrier sheet.

FIG. 1

**Description**

**TECHNICAL FIELD**

The present invention relates to a transparent barrier sheet for packaging employed in the packaging fields of foods and medicines, or a transparent barrier sheet employed for members related to electronic equipment, a transparent barrier sheet at extremely low permeability of gases such as oxygen or water vapor, and a production method of the same.

**BACKGROUND ART**

In recent years, in order to confirm contents, transparent packaging materials have been sought for packaging foods and medicines. Further, in order to minimize effects of permeated oxygen, water vapor, and other gases which adversely affect the content, gas barrier properties are demanded to maintain function and properties of packaged goods. Conventionally, when a high degree of gas barrier properties is demanded, packaging materials have been employed in which foil composed of metals such as aluminum is employed as a gas barring layer. However, the above packaging materials, which employ metal foil as a gas barrier, exhibit a high degree of gas barrier properties, which are not affected by temperature and humidly but have resulted in problems in which it is not possible to confirm contents through the packing material and it is not possible to use a metal detector during inspection.

Consequently, in recent years, in order to enhance the performance, have been developed and proposed, for example, are transparent barrier materials which are prepared in such a manner that a sputtered layer of metal oxides such as silicon oxide or aluminum oxide are provided on one side of a plastic substrate. However, in order to enhance the gas barrier properties, when the thickness of such inorganic material layer is increased beyond a certain value, cracking is induced due to insufficient flexibility and plasticity, whereby the gas barrier properties is degraded.

Further, in order to overcome the above drawbacks, it is proposed to realize excellent gas barrier properties by applying a thin organic layer of a crosslinked structure together with a thin inorganic layer onto a transparent plastic substrate (refer, for example, to Patent Documents 1 and 2).

In the above transparent barrier sheet, the gas barrier function has commonly been realized employing a thin inorganic layer, but metal oxides such as silicon oxide or aluminum oxide occasionally resulted in insufficient achievement for the desired barrier properties. Therefore, disclosed is a layer-on layer configuration carrying a thin metal layer composed of metal nitride (refer, for example, to Patents Documents 3 and 4). However, heretofore, no sufficient investigation has been conducted.

Further, the metal nitride layer, even though it is thin, is capable of exhibiting sufficient gas barrier properties due to its excellent gas barrier properties, whereby it is possible to decrease the overall layer thickness. However, in order to minimize defects such an insufficient surface properties of the substrate, the layer thickness, which is nearly equal to that of metal oxide, is currently provided.

(Patent Document 1) Japanese Patent Publication Open to Public Inspection (hereinafter referred to as JP-A) No. 2003-276115
(Patent Document 2) JP-A No. 2003-300273
(Patent Document 3) JP-A No. 10-507705
(Patent Document 4) JP-A No. 2005-35204

**DISCLOSURE OF THE INVENTION**

**PROBLEMS TO BE SOLVED BY THE INVENTION**

The present invention was achieved to overcome the above conventional technical problems. An object of the present invention is to provide a transparent barrier sheet which exhibits excellent gas barrier properties and excellent bending resistance, and a production method thereof.

**MEANS TO SOLVE THE PROBLEMS**

The above object of the present invention is accomplished employing the following embodiments.

(1) A transparent barrier sheet comprising:

a substrate sheet having thereon a transparent primer layer;
a transparent inorganic thin layer; and

a transparent organic thin layer,
wherein:
the transparent inorganic thin layer comprises silicon nitride or silicon oxy-nitride;
the transparent organic thin layer is formed by polymerizing a radically polymerizable compound or a cationically polymerizable compound; and
the transparent primer layer on the substrate has a surface roughness Ra of 5 nm or less.

(2) A transparent barrier sheet of the above-described item 1,
wherein the cationically polymerizable compound comprises a group selected from the group consisting of an oxirane group, an oxetane group, a tetrahydrofuran group, an oxepane group, a single ring acetal group, a double ring acetal group, an alkenyl ether group, an allene ether group, a ketene acetal group, a lactone group, a cyclic orthoester group or a cyclic carbonate group.
(3) A transparent barrier sheet of the above-described items 1 or 2,
wherein the transparent inorganic thin layer and the transparent organic thin layer are provided in that order on the transparent primer layer of the substrate sheet.
(4) A transparent barrier sheet of the above-described item 3,
wherein a second transparent inorganic thin layer is provided on the transparent organic thin layer.
(5) Another embodiment of the present invention is a transparent barrier sheet of the above-described items 1 or 2,
wherein a second transparent inorganic thin layer; and a second transparent organic thin layer are provided in that order on the transparent organic thin layer, whereby at lease two units each composed of a transparent inorganic thin layer and a transparent organic thin layer are formed on the substrate sheet.
(6) A transparent barrier sheet of any one of the above-described items 1 to 5,
wherein a thickness of the transparent inorganic thin layer is from 10 to 10000 nm.
(7) A method of producing a transparent barrier sheet comprising the steps of:

depositing silicon nitride or silicon oxi-nitride on a substrate sheet having thereon a primer layer employing a catalytic chemical vapor deposition method, a reactive plasma deposition method or an electron cyclotron resonance plasma deposition method so as to form a transparent inorganic thin layer; and
forming a transparent organic thin layer.

(8) A method of producing a transparent barrier sheet of the above-described item 7,
wherein the transparent organic thin layer is formed by the steps of:

depositing on the transparent inorganic thin layer vapors of a radically polymerizable compound and a radical polymerization initiator; or a cationically polymerizable compound; and
polymerizing the deposited vapors by irradiating with actinic rays or by heating.

(9) A method of producing a transparent barrier sheet of the above-described items 7 or 8,
wherein a maximum attained temperature T (in K) of the substrate sheet is controlled to be in the range of 243 to 383 K during the formations of the transparent inorganic thin layer and the transparent organic thin layer.
(10) A method of producing a transparent barrier sheet of the above-described item 9,
wherein the maximum attained temperature T (in K) of the substrate sheet is controlled to satisfy Formula (1):

$$\text{Formula (1)}$$

$$1.21 \leq (T \times S)/1000 \leq 460$$

wherein S (in second) represents a required time to form the transparent inorganic thin layer and the transparent organic thin layer.

**EFFECTS OF THE INVENTION**

Based on the present invention, it was possible to provide a transparent barrier sheet which exhibited excellent gas barrier properties and excellent bending resistance and the production method thereof.

**BRIEF DESCRIPTION OF THE DRAWINGS**

Fig. 1 is a schematic sectional view of a transparent barrier sheet incorporating one unit of a transparent thin inorganic layer/transparent thin organic layer on a substrate sheet provided with a transparent primer layer.

Fig. 2 is a schematic sectional view of a transparent barrier sheet incorporating two units of a transparent thin inorganic layer/transparent thin organic layer on a substrate sheet provided with a transparent primer layer.

Fig. 3 is a schematic sectional view of a transparent barrier sheet incorporating 5 units of a transparent thin inorganic layer/transparent thin organic layer on a substrate sheet provided with a transparent primer layer.

Fig. 4 is a schematic sectional view of a transparent barrier sheet incorporating two units of a transparent thin inorganic layer/transparent thin organic layer on both sides of a substrate sheet coated with a transparent primer sheet on both aforesaid sides.

Fig. 5 is a schematic sectional view of a transparent barrier sheet incorporating a transparent thin inorganic layer/ transparent thin organic layer/transparent thin inorganic layer on a substrate sheet provided with a transparent primer layer.

Fig. 6 is a view showing a casting apparatus employing a catalytic chemical vapor deposition method.

**DESCRIPTION OF SYMBOLS**

11, 21, 31, 41, 61: substrate sheet
12, 22, 32, 42, 42', 62: transparent primer layer
111, 211, 221, 311, 321, 331, 341, 351, 411, 411', 421, 421',
611, 621: transparent thin inorganic layer
112, 212, 222, 312, 322, 332, 342, 352, 412, 412', 422, 422',
612: transparent thin organic layer
50: vacuum vessel
51: substrate sheet provided with a transparent primer layer
52: holding mechanism
53: cooling mechanism
54: heater (tungsten)
55: gas inlet
56: hydrogen gas source
57: ammonia gas source
58: silane gas source
59: shielding member
501: driving device for shielding member
502: heating electric source for heater
503: vacuum pump
504: cooling source
505: device for inlet
506: space
V56, V57, V58: on-off valve

**PREFERRED EMBODIMENTS TO CARRY OUT THE INVENTION**

The transparent barrier sheet of the present invention and the production method thereof will now be detailed.

(Transparent Barrier Sheet)

The transparent barrier sheet of the present invention incorporates a substrate sheet coated with a transparent primer layer having thereon at least one thin transparent inorganic layer, and at least one thin transparent organic layer. Each of the constituting materials of the transparent sheet of the present invention will now be described. The visible light transmittance of the transparent barrier sheet of the present invention is 50 - 95%.

Substrate sheets employed in the present invention may be used without any particular limitation as long as they result in neither dimensional deformation when the following production method is employed, nor curling after coating of a thin layer. Listed as resins to form the sheet may, for example, be polyester based resins such as polyethylene terephthalate (PET), or polyethylene naphthalate; polyolefin based resins such as polyethylene or polypropylene; styrene based resins such as polystyrene or acrylonitrile-styrene copolymers; acryl based resins such as polymethyl methacrylate or methacrylic acid-maleic acid copolymers; cellulose based resins such as triacetyl cellulose; vinyl based resins such as polyvinyl chloride; imido based resins such as polyimide, fluorinate polyimide, or polyetherimide; amido based resins such as nylon 6, nylon 66, or MXD nylon 6; polycarbonate resins composed of bisphenol A, bisphenol Z, or 1,1-bis(4-hydroxyphenyl)-3,3,5-trimethylcyclohexane; polyacrylate resins, fluororesins; polyethersulfone resins; polysulfone resins; polyether ketone resins; or alicyclic polyolefin resins such as alicyclic polyolefin, or alicyclic olefin copolymers.

Substrate sheets include those which have been stretched or not stretched as long as the object of the present invention is not adversely affected, and preferred are those which exhibit sufficient mechanical strength and dimensional stability. Of these, biaxially stretched polyethylene terephthalate or polyethylene naphthalate is preferred for the use of thin substrate sheets. On the other hand, when substrate sheets are relatively thick, the above-cited polyester based resins such as polyethylene terephthalate or polyethylene naphthalate, polyarylate resins, polyether sulfone resins, polycarbonate resins, or alicyclic polyolefin resins are preferred in view of dimensional stability, chemical resistance, and heat resistance.

Further, if desired, various additives may be added to substrate sheets of the present invention in a range which does not adversely affect the present invention. Cited as such additives may, for example, be plasticizers, dyes and pigments, antistatic agents, UV absorbers, antioxidants, minute inorganic particles, peeling enhancing agents, leveling agents, inorganic layer-shaped silicates, and lubricants.

The thickness of the substrates may be appropriately varied depending on the use of the transparent barrier sheet of the present invention. Further, when considering suitability of a packaging material, other than a single resin sheet, it is possible to select and employ appropriate sheets laminated with a different quality sheet. However, when considering machinability during formation of the transparent thin inorganic layer and the thin transparent organic layer described below, in practice, the thickness is preferably in the range of 6 - 400 μm, but is most preferably in the range of 25 - 100 μm. When employed for electronic devices such as liquid crystal display elements, dye type solar batteries, organic or inorganic ELs, electronic paper, or fuel cells, appropriate thickness is chosen based on various uses. Of these, when employed as a substitute of a glass substrate, the substrate is prepared according to glass substrate specifications, and after production, the thickness is preferably in the range of relatively thick 50 - 800 μm, but is most preferably in the range of 50 - 400 μm in order to match with the process for the glass substrate.

Further, when mass productivity of the transparent barrier sheets of the present invention is considered, it is preferable to prepare them in the form of a continuous long-length film so that it is feasible to continuously form the thin transparent inorganic layer and the thin transparent organic layer onto the substrate sheet.

Subsequently, a transparent primer layer, coated onto the substrate sheet, will now be described.

The transparent primer layer applied onto the substrate sheet is provided to enhance adhesion to the thin layer applied thereon and to secure the flatness of the surface of the applied thin layer. By providing the above transparent primer layer having a surface roughness Ra of 5 nm or less, it is possible to minimize defects of the thin transparent inorganic layer due to projections and foreign matter on the substrate sheet, to enhance adhesion between the substrate sheet and the thin transparent inorganic layer, and further, it is possible to prepare a transparent barrier sheet which exhibits excellent bending resistance. The method to provide a surface roughness of 5 nm or less will be described later in the part in which a method to prepare a transparent barrier sheet is described. The surface roughness Ra refers to the average surface roughness value (arithmetic average surface roughness), which is also denoted as a roughness average. The surface roughness Ra, which is a three-dimensional Ra, is defined by the following formula:

$$R_a = \frac{1}{MN} \sum_{j=1}^{N} \sum_{i=1}^{M} |Zij|$$

where M and N are the number of data points in X and Y, respectively, and Z is the surface height relative to the mean plane. Thus, heights are measured at (M x N) points within a specific measured length, i.e., M points in the X direction and N points in the Y direction and a curved roughness surface is determined, in which Zij represents a height at the point corresponding to the i-th point in the X direction and the j-th point in the Y direction.

It is also possible to prepare the transparent primer layer via coating of a resin liquid coating composition prepared by dissolving resins in various solvents and subsequently drying the coating. Further, after drying, if desired, a crosslinking reaction may be performed. Further, it is also possible to preferably employ a layer which is prepared as follows. Any of metal alkoxides, UV radiation curing resins, electron beam curing resins, or heat curing resins is coated in the absence of solvents, or a coating composition prepared by diluting any of the above with solvents is coated, subsequently dried, and cured.

Resins, which are employed to prepare a liquid resin coating composition for the above-mentioned transparent primer layer, upon being dissolved in various solvents, include polyester based resins, urethane based resins, acryl based resins, styrene based resins, cellulose based resins, polyvinyl acetal based resins, and vinyl chloride based resins. It is possible to select and employ any appropriate one(s) from these.

Further listed as metal alkoxides are those metals with alcohol such as methyl alcohol, ethyl alcohol, or isopropyl alcohol, and listed as metals may be silicon, titanium, or zirconium.

As UV radiation curable resins or electron beam curable resins, other than compounds such as styrene based monomers or compounds having an unsaturated double bond in the molecule such as acryl based monomers, selected and employed may be any suitable one(s) from radically polymerizable compounds and cationically polymerizable compounds. A composition prepared by combining the above compounds with crosslinking agents is applied onto substrate sheet to form a layer followed by curing, whereby it is possible to form a transparent primer layer.

Further, heat curable resins are suitably selected. Examples of heat curable resins are selected from combinations with compounds or resins having an epoxy group and a mercapto group, combinations with compounds or resins having an oxirane ring and an amino group, combinations of acid anhydrides with compounds or resins having an amino group, or combinations of compounds or resins having hydroxyl group with compounds or resins having an isocyanate group, other than heat curing resins such as phenol resins, epoxy resins, melamine resins, urea resins, unsaturated polyester, or alkyd resins, which are widely employed, and then employed.

The thickness of the above transparent primer layer is valuable depending on the surface property of the substrate employed. The thickness is commonly in the range of 0.05 - 5.0 $\mu$m, but is preferably in the range of 0.1 - 2.0 $\mu$m. The above transparent primer layer may be composed of a single layer or a plurality of layers.

The thin transparent inorganic layer and the thin transparent organic layer applied onto the transparent primer layer of the substrate sheet coated with the transparent primer layer will now be detailed.

Firstly, it is characterized that the thin transparent inorganic layer according to the present invention is a thin layer composed of silicon nitride or silicon oxy-nitride as a major component. By forming a layer composed of the above silicon nitride or silicon oxy-nitride as a major component, it is possible to make the thickness to secure gas barrier properties thinner than that of the thin inorganic layer composed of metal oxides such as silicon oxide or aluminum oxide.

Silicon nitride or silicon oxy-nitride each are respectively represented by SiN and $SiO_xN_y$. The values of x and y in $SiO_xN_y$ are preferably as follows. When enhancement of water vapor barrier properties is mainly intended, it is preferable that a nitrogen-rich layer is formed resulting in $0 < x < 0.8$ and $0.8 < y < 1.3$.

The thickness of thin transparent inorganic layers containing mainly the above-described silicon nitride or silicon oxy-nitride is commonly 10 - 1,000 nm, but is preferably 20 - 500 nm, more preferably 20 - 200 nm to assure desired gas barrier property and bending resistance.

The thin transparent organic layer will now be detailed.

It is also characterized that the thin transparent organic layer of the present invention is the thin layer which is formed by radically polymerizing radically polymerizable compounds or cationically polymerizing cationically polymerizable compounds.

Radically polymerizable compounds employed to prepare the thin transparent organic layer according to the present invention may be employed without any particular limitation as long as they have a radically polymerizable functional group. Of those, in view of ease of procurement, preferred are compounds having an ethylenic unsaturated double bond.

Cited as compounds having the above ethylenic unsaturated double bond may, for example, be those having a vinyl group in the molecule such as styrene derivatives, vinyl acetate derivatives, or vinylpyrrolidone derivatives, compounds having an allyl group in the molecule, and compounds having an acyloxy group or an acrylamide group in the molecule. Of these, in view of the steric hindrance during radical polymerization, compounds having a (meth)acryloyl group are more preferred. As used herein, a "(meth)acryloyl group" denotes either an acryloyl group or a methacryloyl group.

Examples of the above compounds having a (meth)acryloyl group include, as a compound having one (meth) acryloyl group, (meth)acrylates and (meth)acrylamides of substituted or unsubstituted phenol, nonylphenol, and 2-ethylhexanol, in addition to (meth)acrylates and (meth)acrylamides of alkylene oxide addition products of these alcohols. Compounds having two (meth)acryloyl groups include di(meth)acrylates and (meth)acrylamides of substituted or unsubstituted bisphenol A, bisphenol F, fluorene, or isocyanuric acid, in addition to di(meth)acrylates and (meth)acrylamides of alkylene oxide addition products of the above alcohols, as well as di(meth)acrylates and (meth)acrylamides of polyalkylene glycol such as ethylene glycol or propylene glycol. Compounds having three (meth)acryloyl groups include tri (meth)acrylates and tri(meth)acrylamides of pentaerythritol and trimethylolpropane, as well as tri(meth)acrylates and tri (meth)acrylamides of alkylene oxide addition products of the above alcohols. Compounds having at least four (meth)acryloyl groups include poly(meth)acrylates and poly(meth)acrylamides of pentaerythritol, and dipentaerythritol. Further included are acryl or acrylamide based monomers/oligomers, known in the art, such as urethane acrylates containing a urethane bond as a main chain, polyester acrylates containing an ester bond as a main chain, and epoxy(meth)acrylates which are prepared by adding acrylic acid to epoxy compounds.

Further, in the present invention, suitable compounds may be employed from those exemplified in each of Japanese Patent Publication Open to Public Inspection (hereinafter referred to as JP-A) Nos. 9-104085, 2000-122005, 2000-216049, 2003-172935, 2003-233076, 2003-276115, 2003-322859, 2004-1296, and 2004-359899, 2004-103401, as well as Japanese Patent Publication Open to Public Inspection (under PCT Application) Nos. 8-512256, 11-503195, 2001-508089, 2001-518561, 2002-528568, 2004-532330, 2004-533313, and 2005-524058.

Further, compounds having a plurality of (meth)acryloyl groups may have either or both of (meth)acrylates and (meth)acrylamides.

It is possible to polymerize the aforesaid radically polymerizable compounds, employing methods known in the art, such as an electron beam curing method or an ultraviolet radiation curing method. Of these, when polymerizable compounds are polymerized employing photopolymerization via ultraviolet radiation or visible light, polymerization initiators are necessary as an essential component. Polymerization initiators employed for ultraviolet radiation or visible light are not particularly limited as long as they can generate radicals via radiation, and include carbonyl compounds such as benzophenone, azo compounds such as azobisisobutyronitrile, sulfur compounds such as dibenzothiazolyl sulfide, peroxides such as benzoyl peroxide, halides such as 2-tribromomethanesulfonyl-pyridine, quaternary ammonium salts or substituted or unsubstituted diphenyl iodonium salts, onium compounds such as triphenylsulfonium salts, and metal $\pi$-complexes such as an iron arene complex or a titanocene complex. Further, when the above photopolymerization initiators do not or only slightly absorb laser beams at the wavelength employed for holographic exposure described below, sensitizing dyes may simultaneously be employed to broaden the spectrally sensitive wavelength of the photopolymerization initiators.

On the other hand, as cationically polymerizable compounds employed in the thin transparent organic layer according to the present invention, it is preferable to employ at least one compound which is suitably selected from those having an oxirane group, an oxetane group, a tetrahydrofuran group, an oxepane group, a single ring acetal group, a double ring acetal group, an alkenyl ether group, an allene ether group, a ketene acetal group, a lactone group, a cyclic orthoester group or a cyclic carbonate group.

Examples of the above compounds having a oxetane ring include those described in JP-A Nos. 5-170763, 5-371224, 6-16804, 7-17958, 7-173279, 8-245783, 8-301859, 10-237056, 10-330485, 11-106380, 11-130766, 11-228558, 11-246510, 11-246540, 11-246541, 11-322735, 2000-1482, 2000-26546, 2000-191652, 2000-302774, 2000-336133, 2001-31664, 2001-31665, 2001-31666, 2001-40085, 2003-81958, 2003-89693, 2001-163882, 2001-226365, 2001-278874, 2001-278875, 2001-302651, 2001-342194, 2002-20376, 2002-80581, 2002-193965, 2002-241489, 2002-275171, 2002-275172, 2002-322268, 2003-2881, 2003-12662, 2003-81958, 2004-91347, 2004-149486, 2004-262817, 2005-125731, 2005-171122, 2005-238446, 2005-239573, and 2005-336349, and Japanese Patent Publication Open to Public Inspection under PCT Application) No. 11-500422. These compounds may be employed individually or in combinations of at least two types.

Further employed as compounds having an oxirane ring may be various types of compounds. Specific examples include resins, the terminals of which are modified with a glycidyl group, such as aliphatic polyglycidyl ether, polyalkylene glycol diglycidyl ether, tertiary carboxylic acid monoglycidyl ether, polycondensation products of bisphenol A with epichlorohydrine, polycondensation products of hydrogenated bisphenol A with epichlorohydrine, polycondensation products of brominated bisphenol A with epichlorohydrine, and polycondensation products of bisphenol F with epichlorohydrine, as well as glycidyl modified phenol novolak resins, glycidyl modified o-cresol novolak resins, 3,4-epoxycyclohexenylmethyl-3',4'-epoxycyclohexane carboxylate, 3,4-epoxy-4-methylcyclohexenylmethyl-3',4'-methylcyclohexane carboxylate, 1,2-bis(3,4-epoxy-4-methylcyclohexycenylcarbonyloxy)ethane, and dipentane dioxide. Further, it is also possible to suitably employ the compounds described on pages 778 - 787 of "11290 no Kagaku Shohin (11290 Chemical Products)", Kagaku Kogyo Nippo-Sha, and the compounds described in JP-A No. 2003-341003.

Further listed as compounds having an alkenyl ether group are hydroxyethyl vinyl ether, hydroxylbutyl vinyl ether, dodecyl vinyl ether, propenyl ether propylene carbonate, and cyclohexyl vinyl ether. Listed as compounds having at least two vinyl ether groups may be cyclohexane dimethanol divinyl ether, triethylene glycol divinyl ether, and novolak type divinyl ether. Further, specific examples of compounds having a tetrahydrofuran group, an oxepane group, a single ring acetal group, a double ring acetal group, a lactone group, a cyclic orthoester group or a cyclic carbonate group are those described, for example, in JP-A No. 2004-341016.

Listed as polymerization initiators to polymerize the compounds according to the present invention may be photopolymerization initiators or heat polymerization initiators which allow the oxetane ring and the oxirane ring to undergo cationic polymerization. Of these, photopolymerization initiators may be employed without particular limitation as long as they can generate Br$\phi$nsted acid or Lewis acid. For example, cationic photopolymerization initiators employed in chemical amplification type photoresists and light carving resins (refer to pages 187 - 192 of "Imaging yo Yuuki Zairyo (Organic Materials for Imaging"), edited by Yuuki Electronics Zairyo Kenkyuu Kai, Bunshin Shuppan, (1993)), may, if suitable, be selected and then employed.

Specific examples of such cationic photopolymerization initiators include s-triazine compounds substituted with a trihalomethyl group, such as 2,4,6-tris(trichloromethyl)-1,3,5-triazine, 2-(4-methoxyphenyl)-4,6-bis(trichloromethyl)-1,3,5-triazine, and the compounds described in JP-A No. 2-306247; iron arene complexes such as [$\eta$6-i-propylbenzene] or [$\eta$5-cyclopentadienyl]iron hexafluorophosphate; onium salts such as diphenyliodonium hexafluorophosphate, diphenyliodonium hexafluoroantimonate, triphenylsulfonium hexafluorophosphate, triphenyltellurium hexafluoroarylcyanate, or diphenyl-4-thiophenoxysulfonium hexafluoroantimonate; and aryldiazonium salts, diazoketone, o-nitrobenzyl ester, sulfonic acid ester, disulfone derivatives, imidosulfonate derivatives, and silanol-aluminum complexes described in JP-A No. 62-57646. Further, any of those described in JP-A Nos. 5-107999, 5-181271, 8-16080, 8-305262, 2000-47552, 2003-66816; U.S. Patent No. 5,759,721, and European Patent No. 1,029,258 may, if suitable, be selected and then employed.

Further, without particular limitation, employed as the cationic heat polymerization initiators may be onium salts such as sulfonium salts, ammonium salts, or phosphonium salts and silanol-aluminum complexes. Of these, listed as cationic heat polymerization initiators, when other essential components result in no problem while heated at equal to or higher than 150 °C, are the benzylsulfonium salts described in JP-A Nos. 58-37003 and 63-223002, the trialkylsulfonium salts described in JP-A No. 56-152838, and the compounds described in JP-A Nos. 63-8365, 63-8366, 1-83060, 1-290658, 2-1470, 2-196812, 2-232253, 3-17101, 3-47164, 3-48654, 3-145459, 3-200761, 3-237107, 4-1177, 4-210673, 8-188569, 8-188570, 11-29609, 11-255739, and 2001-55374. These cationic heat polymerization initiators may be employed individually or in combinations of at least two types.

The amount of the above polymerization initiator, when the amount of the cationically polymerizable compound is to be 100 parts by weight, is commonly in the range of 0.01 - 30 parts by weight, but is preferably in the range of 0.05 - 20 parts by weight.

Further, the thickness of the thin transparent organic layer is commonly 50 nm - 5.0 $\mu$m, but is preferably 50 nm - 2.0 $\mu$m in terms of achieving flatness and bending resistance.

In the present invention, it is preferable that a thin transparent inorganic layer and a thin transparent organic layer are applied in the stated order onto the substrate sheet coated with the transparent primer layer, since defects such as cracking are minimized when external stress is applied to the thin transparent inorganic layer coated to secure gas barrier properties. Consequently, in order to secure gas barrier properties, it is preferable that a thin transparent inorganic layer is further applied onto the thin transparent organic layer.

In order to enhance gas barrier properties and bending resistance at high temperature and high humidity, when a thin transparent inorganic layer and a thin transparent organic layer are regarded as one unit, it is preferable that at least two such units are applied onto the transparent primer layer on the substrate sheet coated with the transparent primer layer. Numbers of coated units are commonly 2 - 10 units, but are preferably 2 - 5 units.

In the above case in which a plurality of units is applied, when it is necessary to consider abrasion resistance, it is preferable that the thickness of the thin transparent organic layer, which is to be the uppermost layer, is more than that of the lower thin transparent organic layer. In such a case, it is preferable to satisfy the following relationship;

$$1 < R2/R1 \leq 10$$

wherein R1 represent the maximum layer thickness of the lower transparent organic layer, while R2 represents the thickness of the uppermost thin transparent organic layer. Further, the thickness of the thin transparent inorganic layer and the thin transparent organic layer, other than the uppermost thin transparent organic layer, are as follows. The thickness of the thin transparent inorganic layer is commonly 10 - 1,000 nm, but is preferably 20 - 500 nm. The thickness of the thin transparent organic layer is commonly 50 nm - 2.0 $\mu$m, but is preferably 50 nm - 1.0 $\mu$m.

Further, in the transparent barrier sheet of the present invention, other than the above-mentioned essential layers, if desirable, coated may be functional layers such as an antistatic layer, an adhesion layer, an electrically conductive layer, an antireflection layer, an ultraviolet radiation protective layer. Coated location may be suitably selected in response to the use.

(Production Method of Transparent Barrier Sheet)

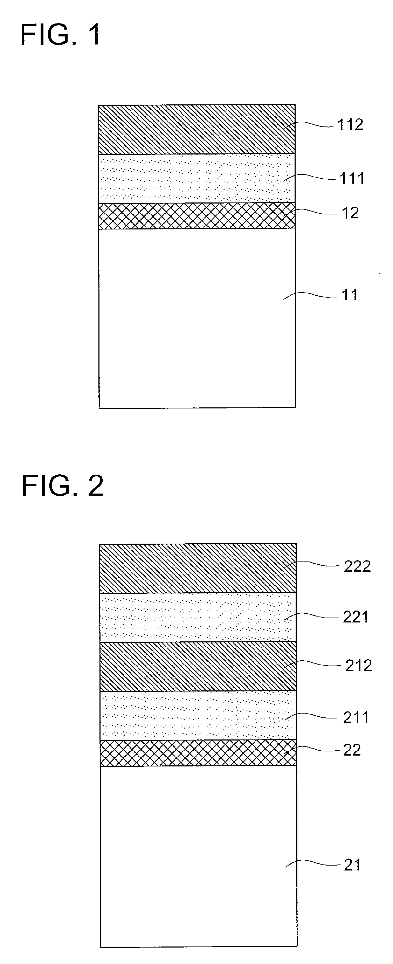

Figs. 1 - 5 are schematic sectional views of the transparent barrier sheets of the present invention. However, if embodiments are in the range of the present invention, the present invention is not limited to these embodiments.

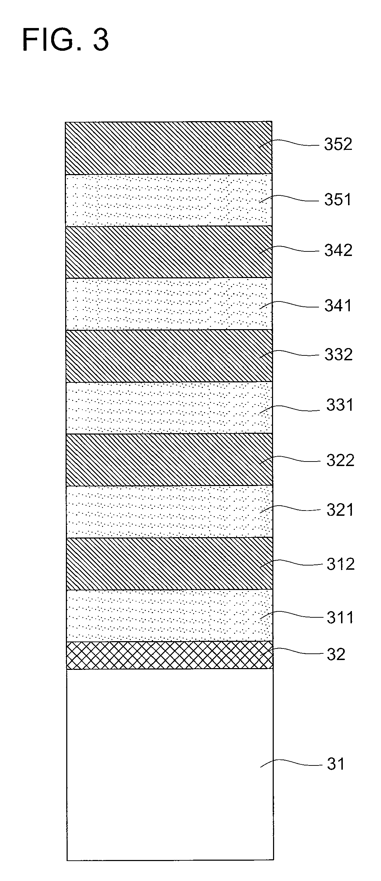

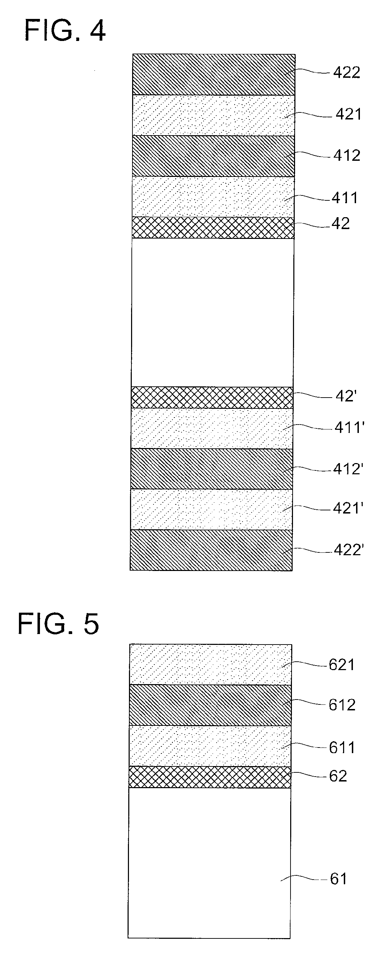

Fig. 1 shows that coated onto substrate sheet 11 are transparent primer layer 12, thin transparent inorganic layer 111, and thin transparent organic layer 112 in the stated order. Fig. 2 shows that when thin transparent inorganic layer 211 and thin transparent organic layer 212 are regarded as one unit, two units are applied onto transparent primer layer 22 of substrate sheet 21 coated with transparent primer layer 22. Fig. 3 shows that 5 units are coated compared to two units in Fig. 2. Fig. 4 shows that both sides of a substrate sheet are coated with transparent primer layers 42 and 42'. Fig. 5 shows that transparent primer layer 62, thin transparent inorganic layer 611, thin transparent organic layer 612, and thin transparent inorganic layer 621 are applied in the stated order onto substrate sheet 61.

Transparent primer layer composition is prepared by blending the above-mentioned transparent primer layer forming components or if desirable, dissolving them in solvents or dispersing them.

When a dispersion is required to form a liquid coating composition, it is possible to select any of the suitable homogenizers known in the art, such as a two-roller mill, a three-roller mill, a ball mill, a pebble mill, a COBOL mill, a tron mill, a sand mill, a sand grinder, a SQEGVARI attritor, a high speed impeller homogenizer, a high speed stone mill, a high speed impact mill, DISPER, a high speed mixer, a homogenizer, an ultrasonic homogenizer, an open kneader, or a continuous kneader, and then employed.

Further listed as solvents to employ for dissolution, when required: are water; ketones such as methyl ethyl ketone, methyl isobutyl ketone, or cyclohexanone; alcohols such as ethyl alcohol, n-propyl alcohol, or isopropyl alcohol; aliphatic hydrocarbons such as heptane or cyclohexane; aromatics such as toluene or xylene; glycols such as ethylene glycol or diethylene glycol; ether alcohols such as ethylene glycol monomethyl ether; ethers such as tetrahydrofuran, 1,3-dioxysolan or 1,4-dioxane; and halogen compounds such as dichloromethane or chloroform.

It is possible to apply the transparent primer layer forming composition, prepared as above, onto a substrate sheet, employing, for example, a roller coating method, a gravure roller coating method, a direct gravure roller coating method, an air doctor coating method, a rod coating method, a kiss roller coating method, a squeezing roller coating method, a reverse roller coating method, a curtain flow coating method, a fountain method, a transfer coating method, a spray coating method, a dip coating method, or other appropriate methods. Subsequently, the resulting coating is heat-dried, followed by an aging treatment, whereby it is possible to apply a transparent primer layer onto a substrate sheet.

In the present invention, to minimize problems which occur during coating the thin transparent inorganic layer described below, the surface roughness of the transparent primer layer coated onto a substrate sheet is regulated to be at most 5 nm. To realize the above surface roughness, when solvents are employed in the above transparent primer layer forming composition, it is preferable that after sufficiently leveling the surface of the coating, the above solvents are gradually dried during drying. When the transparent primer layer composition is formed without solvents, it is preferable that after leveling surface roughness R to be at most 5 nm, cross-linking or polymerization is carried out. Further, it is possible to physically reach surface roughness Ra of the coated thin transparent inorganic layer to be at most 5 nm. An example of the above physical method capable of reaching surface roughness Ra to be at most 5 nm include a method in which a specular surface roller or plate at roughness Ra of at most 5 nm is brought into contact with the surface of the transparent primer layer, followed by simple pressing, or pressing under application of heat.

Further, in the present invention, when the transparent primer layer forming composition is applied onto a substrate sheet, it is preferable that after performing a suitable surface treatment selected from a flame treatment, an ozone treatment, a glow discharge treatment, a corona discharge treatment, a plasma treatment, a vacuum ultraviolet radiation exposure treatment, an electron beam exposure treatment, or a radiation exposure treatment, the transparent primer layer forming composition is applied onto a substrate sheet. By treating the surface of the substrate sheet as described above, it is possible to enhance adhesion between the substrate sheet and the transparent primer layer.

When the employed transparent primer layer forming components are the same as the thin transparent organic layer forming compositions, the same method as used to coat the thin transparent organic layer, to be described below, may be employed.

The forming method of the thin transparent inorganic layer containing mainly silicon nitride or silicon oxy-nitride formed on the transparent primer layer will now be detailed.

Listed as forming methods of the thin transparent inorganic layer containing mainly silicon nitride or silicon oxy-nitride may, for example, be a vacuum deposition method, a sputtering method, an ion plating method, a reactive plasma deposition method, an method employing an electron cyclotron resonance plasma, a plasma chemical vapor deposition method, a thermochemical vapor deposition method, a photochemical vapor deposition method, a catalytic chemical vapor deposition method, and a vacuum ultraviolet radiation chemical vapor deposition method. Of these methods, it is preferable that the thin transparent inorganic layer is formed employing at least one of the catalytic chemical vapor deposition method (namely a Cat-CVD method), the reactive plasma deposition method (namely an RPD method), and the electron cyclotron resonance (ECR) plasma deposition method, which result in a layer exhibiting a relatively flat and smooth surface due to relatively little surface roughness on the formed thin transparent inorganic layer. Among them, more preferred are the reactive plasma deposition method (namely an RPD method), and the electron cyclotron resonance (ECR) plasma deposition method, which result in a layer exhibiting a relatively flat and smooth surface due to relatively little surface roughness on the formed thin transparent inorganic layer.

A specific method and deposition device of the above catalytic chemical vapor deposition method may suitably be selected from those described, for example, in JP-A Nos. 2002-69644, 2002-69646, 2002-299259, 2004-211160, 2004-217966, 2004-292877, 2004-315899, and 2005-179693, and may then be employed upon improvement of the shape suitable for the purpose of the present invention.

Further, a specific method and deposition device of the reactive plasma vapor deposition method may suitably be selected from those described, for example, in JP-A Nos. 2001-262323, 2001-295031, 2001-348660, 2001-348662, 2002-30426, 2002-53950, 2002-60929, 2002-115049, 2002-180240, 2002-217131, 2002-249871, 2003-105526, 2004-76025, and 2005-34831, and may then be employed upon improvement of the shape suitable for the purpose of the present invention.

Still further, a specific method and deposition device of the ECR plasma deposition method may suitably be selected from those described, for example, on pages 152 - 154 and 226 in Tatsuo Asagi, "Hakumaku Sakusei no Kiso (Basis of Thin Layer Formation)" (published by Nikkan Kogyo Shinbun Sha, March 1996), and in JP-A Nos. 3-197682, 4-216628, 4-257224, 4-311036, 5-70955, 5-90247, 5-9742, 5-117867, 5-129281, 5-171435, 6-244175, 6-280000, 7-263359, 7-335575, 8-78333, 9-17598, 2003-129236, 2003-303698, and 2005-307222, and may then be employed upon improvement of the shape suitable for the purpose of the present invention.

Further, employed as the deposition method of the thin transparent organic layer formed on the above-mentioned thin transparent inorganic layer containing mainly silicon nitride or silicon oxy-nitride may be a coating when the above primer layer is formed, or a deposition method. However, in the transparent barrier sheet of the present invention, it is preferable to employ the deposition method so that the thin transparent inorganic layer, functioning as a barrier layer, is not damaged.

The above thin transparent organic layer prepared via coating employing a deposition method is formed as follows. A layer composed of radically polymerizable compounds or cationically polymerizable compounds, and if desired, any initiators to initiate the polymerization reaction of the above compounds, is formed employing a deposition method and subsequently, a thin layer is formed via polymerization of polymerizable compounds employing a method such as exposure to actinic radiation or heating.

Specifically, it is possible to form a thin polymerization layer of radically polymerizable compounds on the thin transparent inorganic layer in such a manner that the layer of a composition incorporating radically polymerizable compounds as an essential component is formed on the thin transparent inorganic layer, employing a deposition method, followed by exposure to electron beams to polymerize the radically polymerizable compounds. Alternatively, it is possible to form a thin transparent organic layer in such a manner that a composition incorporating radically polymerizable compounds and photopolymerization initiators, which generates radicals via exposure to ultraviolet radiation, as an essential component is deposited on the thin transparent inorganic layer, followed by polymerization of the radically polymerizable compounds via exposure to radiation capable of initiating polymerization reaction in the presence of photopolymerization initiators.

Further, it is possible to form a thin transparent organic layer via polymerization of cationically polymerizable compounds in such a manner that after coating a composition incorporating cationically polymerizable compounds as an essential component on the thin transparent inorganic layer via a deposition method, when photopolymerization initiators are employed as a polymerization initiator, actinic radiation such as ultraviolet radiation, visible light or near infrared radiation, capable of initiating a polymerization reaction in the presence of photopolymerization initiators, is exposed to polymerize the cationically polymerizable compounds.

Further, when heat polymerization initiators are employed as a polymerization initiator, polymerization reaction is initiated from the heat polymerization initiators while heated, whereby it is possible to form the thin transparent organic layer via cationically polymerizing compounds. When a thin transparent inorganic layer and a thin transparent organic layer are continuously applied onto a film-type substrate sheet, or when productivity is the main concern, it is preferable to employ a composition containing cationically polymerization compound as an essential component with a photopolymerization initiator with which tend to simplify the polymerization process.

In order to deposit a composition incorporating a radically polymerizable compound or a cationically polymerizable compound as an essential component, deposition conditions may be set for each of the compounds. Further, when no polymerization reaction proceeds during layer formation via deposition and no problem occurs due to some difference in the deposition rate via monomers, deposition conditions may be set for the mixture of compositions.

A specific method and layer forming device of the above-mentioned deposition method may suitably be selected from those described, for example, in JP-A Nos. 5-125520, 6-316757, 7-26023, 9-104085, 9-272703, 9-31115, 10-92800, 10-168559, 10-289902, 11-172418, 2000-87224, 2000-122005, 2000-127186, 2000-216049, 2000-348971, 2003-3250, 2003-172935, 2003-233076, 2003-276115, 2003-300273, 2003-322859, 2003-335880, 2003-341003, 2004-1296, 2004-359899, 2004-103401, 2005-14483, 2005-125731, and 2005-178010, as well as in Japanese Patent Publication Open to Public Inspection (under PCT Application) Nos. 8-503099, 8-512256, 11-503195, 2001-508089, 2001-518561, 2002-528568, 2004-524958, 2004-532330, 2004-533313, and 2005-524058, and may then be employed upon improvement of the shape suitable for the purpose of the present invention.

Further, to minimize thermal deformation of substrate sheets during preparation of the transparent barrier sheet of the present invention, it is preferable to regulate the maximum attained temperature T, in K of the substrate sheet to the range of 243 - 383 K, but is more preferably to regulate it to the range of 243 - 333 K. Further, it is more preferable that maximum attained temperatures T (in K) of the substrate sheet is within the range represented by following Formula (3):

$$\text{Formula (3)} \quad 0.46 \leq T/Tg \leq 0.98$$

wherein Tg (in K) represents the glass transition temperature of the resin employed in the substrate sheet.

Further, when a rolled film product is employed as a substrate sheet employed to form a transparent barrier sheet, tension is applied to the unwinding side and the winding side during casting, and a thin transparent inorganic layer and a thin transparent organic layer are cast while being conveyed. In such a case, rather than casting in the form of substrate sheets, due to occasional cases in which thermal deformation of the substrate sheet is enhanced, it is preferable to satisfy the conditions of following Formula (1) wherein T (in K) represents a maximum attained temperature and S (in seconds) represents the casting time, so that it is possible to produce transparent barrier sheets of minimal defects. Further, it is preferable to satisfy the conditions of Formula (2) since it is possible to produce transparent barrier sheets with fewer defects. Maximum attained temperature T (in K) of the substrate sheet during formation of the thin transparent organic layer and the thin transparent inorganic layer and casting time S (in seconds), as described herein, relate to the process forming single layer. When the thin transparent organic layer and the thin transparent inorganic layer are superposed to form a plurality of layers, above T and S represent casting conditions of each of the single layers. Further, casting time, as described herein, represents the casting time at a certain point of the substrate sheet.

$$\text{Formula (1)} \quad 1.21 \leq (T \times S)/1000 \leq 460$$

$$\text{Formula (2)} \quad 1.21 \leq (T \times S)/1000 \leq 350$$

On the other hand, in the transparent barrier sheet of the present invention, other than the above-mentioned essential layers, functional layers such as an antistatic layer, an adhesion layer, an antireflection layer, an ultraviolet radiation protective layer or a near infrared radiation protective layer, which are provided to meet requirements, may be coated via suitable selection of the coating method employed for the above-mentioned transparent primer layer, thin transparent inorganic layer or thin transparent organic layer.

**EXAMPLES**

The barrier sheet of the present invention will now be described with reference to specific examples, however the present invention is not limited thereto. "Parts" represent parts by weight unless otherwise specified.

Example 1

(Preparation of Transparent Barrier Sheets 1-A - 1-G)

A 125 μm thick biaxially stretched polyethylene terephthalate film (COSMOSHINE A-4300, produced by TOYOBO Co., Ltd.) was prepared. Subsequently, 1,4-butanediol glycidyl ether and 1,3-diaminopropane were independently placed in an organic deposition source, followed by flash heating. After completion of evaporation of impurities, the deposition shutter was opened and a 1.0 μm thick transparent primer layer was formed on one side on the above substrate sheet via deposition polymerization. The surface of the resultant transparent primer layer was evaluated at 5 positions, employing a non-contact three-dimensional surface shape meter (WYKO NT1100, produced by Veeco Co.), resulting in average surface roughness Ra of 4.0 nm.

A 10 °C cooling plate was placed on the reverse side of the substrate that was provided with a transparent primer layer. Subsequently, a thin transparent inorganic layer composed of silicon oxy-nitride was formed under layer forming conditions of a discharge electric current of 120 A and a layer forming pressure of 0.1 Pa, as well as under an ambient gas condition of argon : oxygen : nitrogen = 1 : 0 : 5 or under an exchanged condition of argon : oxygen : nitrogen = 1 : 5 : 0, while employing silicon as a solid target, employing a reactive type plasma vapor deposition apparatus (a small sized plasma layer forming apparatus: compatible with 370 x 480 mm, produced by Sumitomo Heavy Industries, Ltd.).

The composition ratio of the resulting thin transparent inorganic layer was determined via XPS (X-ray photoelectron spectroscopy) and shown in Table 1,

On the reverse of the substrate sheet coated with the transparent primer layer having thereon the above thin transparent inorganic layer, placed was a 10 °C cooling plate and loaded in a vacuum tank. Separately, a thin transparent organic layer forming composition was prepared by completely dissolving 80 parts of 3,4-epoxycyclohexenylmethyl-3', 4'-epoxycyclohexane carboxylate, 18 parts of 1,4-butanediol glycidyl ether, and 2 part of diallyliodonium hexafluoroantimonate. After lowering the pressure in the tank to an order of $10^{-4}$ Pa, the resulting composition was introduced into an organic deposition source. Subsequently, heating the resistor was initiated, and when impurities were completely vaporized, the deposition shutter was opened, whereby a thin transparent organic layer was deposited. Thereafter, UV at an integral radiation of 500 mJ/cm$^2$ was exposed to form a thin transparent organic layer, whereby each of Transparent Barrier Sheets 1-A - 1-G was prepared.

Table 1 shows the layer thickness and the layer forming time during layer formation of the resulting thin transparent inorganic and organic layers, and the maximum attained temperature T (in K) of the substrate sheet. Maximum attained temperature T (in K) during layer formation was determined as follows. A thermo-label was adhered onto the surface of the formed layer and after forming the thin layer, the temperature was confirmed.

Resulting transparent barrier sheets were evaluated for gas barrier properties and bending resistance, as described below. Table 1 shows the results.

(Preparation of Transparent Barrier Sheet R-1)

A biaxially stretched polyethylene terephthalate having a thickness of 125 μm (COSMOSHINE A-4300 produced by TOYOBO Co., Ltd.) film was used as a substrate sheet. It was provided with a transparent primer layer on both sides, and was placed in a vacuum tank. After lowering the pressure to an order of $10^{-4}$ Pa, a thin transparent inorganic layer composed of silicon oxide of 60 nm thick was formed employing the electron beam deposition method while using silicon oxide as a target.

Thereafter, in the state in which the degree of vacuum in the vacuum tank was stabilized in an order of $10^{-4}$ Pa, heating the resistor was initiated. When vaporization of impurities was completed, the deposition shutter was opened and a thin transparent inorganic layer having a thickness of 100 nm was deposited employing an uncured resin composed of one part of a photopolymerization initiator (IRUGACURE 907, produced by Ciba Specialty Chemicals Co.) to 100 parts of bifunctional dicyclopentadienyl diacrylate as an organic deposition source.

After closing the deposition shutter, the UV lamp shutter was opened, and the monomers were cured at an integral radiation of 500 mJ/cm$^2$. By forming the thin transparent organic layer, described as above, Transparent Barrier Sheets R-1 was prepared as a comparative.

Table 1 shows the thickness of the resulting thin transparent inorganic and organic layers, the layer forming time during layer formation, and the maximum attained temperature T (in K) of the substrate sheet during layer formation. Maximum attained temperature T (in K) during layer formation was determined as follows. A thermo-label was adhered onto the surface of the formed layer and after forming the thin layer, the temperature was confirmed.

The transparent barrier sheets, prepared as above, were evaluated for gas barrier properties and bending resistance, as described below. Table 1 shows the results.

(Evaluation of Gas Barrier Properties)

(Evaluation of Water Vapor Barrier Properties)

Water vapor barrier properties of each of the transparent barrier sheets, prepared via the above method, were determined at 50 °C and 100% relative humidity, employing a water vapor permeability meter (Model 7000-WVTR Analyzer, produced by SYSTECH INSTRUMENT Co. Ltd.) Table 1 shows the results.

(Evaluation of Oxygen Barrier Properties)

Oxygen permeability of each of the transparent barrier sheets, prepared via the above method, was determined at 50 °C and 0% relative humidity, employing an oxygen permeability meter (Model 8001-OTR Analyzer, produced by SYSTECH INSTRUMENT Co. Ltd.) based on ASTM D-3985. Table 1 shows the results.

(Evaluation of Bending Resistance)

Each of the transparent barrier sheets, prepared via the above method, was subjected to the following processes (a) and (b) each 10 times alternatively repeated. The above sheet was evaluated in the same manner as for water vapor barrier properties.

(a) To bent to an angle of 180 degrees along a 30 mm$\phi$ stainless steel rod while the thin layer was oriented to the outer side.
(b) To bent to an angle of 180 degrees along a 30 mm$\phi$ stainless steel rod while the thin layer was oriented to the inner side.

EP 2 000 297 A1

Table 1

| | | | Inv. | Inv. | Inv. | Inv. |
|---|---|---|---|---|---|---|
| Transparent Barrier Sheet No. | | | 1-A | 1-B | 1-C | 1-D |
| Glass Transition Temperature of Substrate Sheet Component | | Tg [K] | 340 | 340 | 340 | 340 |
| Thin Transparent Inorganic Layer | Composition of thin inorganic layer | Si:O:N | 1:0.20:1.20 | 1:0.26:1.16 | 1:0.56:0.96 | 1:0.56:0.96 |
| | Layer Thickness | [nm] | 60 | 100 | 200 | 200 |
| | *1 | T [K] | 288 | 288 | 288 | 288 |
| | Layer Firming Time | S (seconds) | 20 | 40 | 70 | 70 |
| | | T x S/1000 (K·second) | 5.76 | 11.52 | 20.16 | 20.16 |
| Thin Transparent Organic Layer | Layer Thickness | [nm] | 100 | 200 | 200 | 300 |
| | *1 | T [K] | 288 | 288 | 288 | 293 |
| | Layer Forming Time | S (seconds) | 80 | 160 | 240 | 240 |
| | | T x S/1000 (K·second) | 23.0 | 46.1 | 69.1 | 70.3 |
| Evaluation of Gas Barrier Properties | Water Vapor Permeability | (g/m$^2$·24hr· 50 °C·90%) | <0.001 | <0.001 | 0.003 | 0.003 |
| | Oxygen Permeability | (ml/m$^2$·24hr· 50 °C·0%) | 0.016 | 0.011 | <0.008 | <0.008 |
| Evaluation of Bending Resistance | Water Vapor Permeability | (g/m$^2$·24hr· 50 °C·90%) | 0.017 | 0.028 | 0.006 | 0.005 |

Inv.: Present Invention, Comp.: Comparative Example, *1: Maximum Attained Temperature

14

Table 1(Cont'd)

| | | | Inv. | Inv. | Inv. | Comp. |
|---|---|---|---|---|---|---|
| Transparent Barrier Sheet No. | | | 1-E | 1-F | 1-G | R-1 |
| Glass Transition Temperature of Substrate Sheet Component | | Tg[K] | 340 | 340 | 340 | 340 |
| Thin Transparent Inorganic Layer | Composition of thin inorganic layer | Si:O:N | 1:0.56:0.96 | 1:0.98:0.68 | 1:1.22:0.52 | 1:2.00:0 |
| | Layer Thickness | [nm] | 200 | 200 | 200 | 60 |
| | *1 | T[K] | 288 | 288 | 288 | 333 |
| | Layer Firming Time | S (seconds) | 70 | 65 | 65 | 60 |
| | | T x S/1000 (K·second) | 20.16 | 18.72 | 18.72 | 20.0 |
| Thin Transparent Organic Layer | Layer Thickness | [nm] | 400 | 300 | 300 | 100 |
| | *1 | T[K] | 298 | 293 | 293 | 293 |
| | Layer Forming Time | S (seconds) | 240 | 240 | 240 | 75 |
| | | T x S/1000 (K·second) | 71.5 | 70.3 | 70.3 | 22.0 |
| Evaluation of Gas Barrier Properties | Water Vapor Permeability | (g/m²·24hr· 50 °C·90%) | 0.004 | 0.005 | 0.005 | 0.065 |
| | Oxygen Permeability | (ml/m²·24hr· 50 °C·0%) | <0.008 | <0.008 | 0.010 | 0.118 |
| Evaluation of Bending Resistance | Water Vapor Permeability | (g/m²·24hr· 50 °C·90%) | 0.004 | 0.006 | 0.007 | 0.143 |

Inv.: Present Invention, Comp.: Comparative Example, *1: Maximum Attained Temperature

As can be seen from Table 1, Transparent Barrier Sheets 1-A - 1-G exhibited superior gas barrier properties and bending resistance to Comparative Barrier Sheets R-1.

Example 2

(Preparation of Transparent Barrier Sheets 2-A - 2-D)

A 100 $\mu$m thick polyether sulfone film (SUMILITE FG-5300, produced by Sumitomo Bakelite Co., Ltd.) was prepared as a substrate sheet. After one side was subjected to a corona discharge treatment, 1,4-butanediol and 1,3-diaminopropane were charged to a separate organic deposition source. Subsequently, flash heating was initiated in each of them. After impurities were completely vaporized, a transparent primer layer was formed in such a manner that by opening the deposition shutter, deposition polymerization was carried out on the substrate sheet. The surface of the resultant transparent primer layer was evaluated at 5 positions, employing a non-contact three-dimensional surface shape meter (WYKO NT1100, produced by Veeco Co.), resulting in average surface roughness Ra of 4.5 nm.
Subsequently, each of Transparent Barrier Sheets 2-A - 2-D was produced by forming a thin transparent inorganic layer and a thin transparent organic layer, employing the methods described in following 1) and 2).

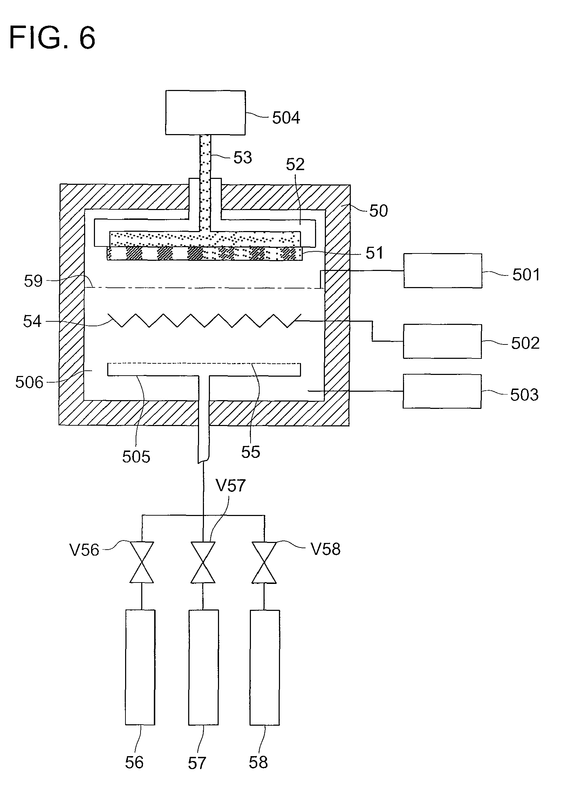

1) Preparation of the thin transparent inorganic layer: The deposition apparatus, shown in Fig. 6, was employed, utilizing the catalytic chemical vapor deposition method. Transparent primer layer coated substrate sheet 51 came into close contact with holding mechanism 52 as a substrate holder and placed in vacuum vessel 50. Thereafter, the pressure in the vacuum vessel 50 was reduced to at most 2 x $10^{-4}$ Pa, employing vacuum pump 503, and subsequently, holding mechanism 52, as a substrate holder, was cooled to 0 °C.
Subsequently, on-off valve V56 for hydrogen source 56 was opened and on-off valve V57 for ammonia gas source 57 was also opened, followed by introduction of hydrogen gas and ammonia gas into vacuum vessel 50. In order to decompose and activate these introduced gases, linear heater 54 arranged between gas inlet 55 and transparent primer layer coated substrate sheet 51 was heated to 1,800 °C.
Subsequently, shielding member 59, arranged between heater 54 and transparent primer layer coated substrate sheet 51, was opened, whereby the surface of transparent primer layer coated substrate sheet 51 was exposed to decomposition active spices of hydrogen gas and ammonia gas over 20 seconds.
Thereafter, while maintaining heater 54 at 1,800 °C, shielding member 59 was temporarily closed, and on-off valve V58 for silane gas source 58 was opened, followed by introduction of silane gas into vacuum vessel 50. Thereafter, shielding member was again opened, and 60 nm thick silicon nitride layer was formed on the surface of transparent primer layer coated substrate sheet 51.
2) Preparation of thin transparent organic layer: A 10 °C cooling plate was placed on the reverse side of a substrate sheet coated with the transparent primer layer having thereon the thin transparent inorganic layer and was placed in a vacuum tank. The pressure of the vacuum tank was reduced to an order of $10^{-4}$ Pa. Separately, the thin transparent organic layer forming composition, described in Table 2, was introduced into the organic deposition source, followed by initiation resistor heating. When impurities were completely evaporated, the deposition shutter was opened, whereby a thin transparent organic layer was deposited. Thereafter, UV at an integral radiation of 500 mJ/cm$^2$ was emitted, whereby a thin transparent organic layer was formed.

Table 2 shows the layer thickness and the layer forming time during layer formation of the resulting thin transparent inorganic and organic layers, and the maximum attained temperature T (in K) of the substrate sheet. Maximum attained temperature T (in K) during layer formation was determined as follows. A thermo-label was adhered onto the surface of the formed layer and after forming the thin layer, the temperature was confirmed.
The resulting transparent barrier sheet was evaluated for gas barrier properties and bending resistance, employing the same methods as in Example 1. Table 2 shows the results.

(Preparation of Transparent Barrier Sheet R-2)

A polyether sulfone film having a thickness of 100 $\mu$m (SUMILITE FS-5300, produced by Sumitomo Bakelite Co. Ltd.) was placed in a vacuum tank. After lowering the pressure to an order of $10^{-4}$ Pa, a thin transparent inorganic layer composed of silicon oxide of 60 nm thick was formed employing the electron beam deposition method while using silicon oxide as a target. Thereafter, in the state in which the degree of vacuum in the vacuum tank was stabilized in an order of $10^{-4}$ Pa, heating the resistor was initiated. When vaporization of impurities was completed, the deposition shutter was opened and a thin transparent inorganic layer having a thickness of 100 nm was deposited employing an uncured resin composed of one part of a photopolymerization initiator (IRUGACURE 907, produced by Ciba Specialty Chemicals Co.) to 100 parts of bifunctional dicyclopentadienyl diacrylate as an organic deposition source. After closing the deposition shutter, the UV lamp shutter was opened, and the monomers were cured at an integral radiation of 500 mJ/cm$^2$. By

forming the thin transparent organic layer, described as above, Transparent Barrier Sheets R-2 was prepared as a comparative.

The resulting transparent barrier sheet was evaluated for gas barrier properties and bending resistance, employing the same methods as in Example 1. Table 2 shows the results.

Table 2

| | | | Inv. | Inv. | Inv. | Inv. | Comp. |
|---|---|---|---|---|---|---|---|
| Transparent Barrier Sheet No. | | | 2-A | 2-B | 2-C | 2-D | R-2 |
| Glass Transition Temperature of Substrate Sheet Component | | Tg(K) | 496 | 496 | 496 | 496 | 496 |
| Thin Transparent Inorganic Layer | Layer Thickness | [nm] | 60 | 60 | 60 | 60 | 60 |
| | Maximum Attained Temperature | T[K] | 298 | 298 | 298 | 298 | 333 |
| | Layer Forming Time | S (seconds) | 900 | 900 | 900 | 900 | 60 |
| | | T x S/1000 (K·second) | 268 | 268 | 268 | 268 | 20.0 |
| | Layer Thickness | [nm] | 60 | 100 | 200 | 300 | 100 |
| | Maximum Attained Temperature | T[K] | 288 | 288 | 298 | 298 | 293 |
| | Layer Forming Time | S (seconds) | 50 | 80 | 155 | 230 | 75 |
| | | T x S/1000 (K·second) | 14.4 | 23.0 | 46.2 | 68.5 | 22.0 |
| Evaluation of Gas Barrier Properties | Water Vapor Permeability | (g/m$^2$·24hr·50 °C·90%) | <0.001 | <0.001 | <0.001 | <0.001 | 0.031 |
| | Oxygen Permeability | (ml/m$^2$·24hr·50 °C·0%) | <0.008 | <0.008 | <0.008 | <0.008 | 0.054 |
| Evaluation of Bending Resistance | Water Vapor Permeability | (g/m$^2$·24hr·50 °C·90%) | 0.015 | 0.014 | 0.014 | 0.013 | 0.104 |
| Inv.: Present Invention, Comp.: Comparative Example | | | | | | | |

As can be seen from Table 2, Barrier Sheets 2-A - 2-D of the present invention exhibited the desired gas barrier properties as well as desired bending resistance contrary to Comparative Barrier Sheets R-2.

Example 3

(Preparation of Transparent Barrier Sheets 3A - 3-F)

One side of a 100 μ thick cycloolefin based resin film (ZEONOR ZF16, produced by OPTES Inc.) as a substrate sheet was subjected to a corona discharge treatment. Subsequently, a coating composition prepared by blending 98 parts of [1-ethyl(3-oxcetanyl)]methyl ether and 2 parts of diphenyl-4-thiophenoxysulfonium hexafluoroantimonate was applied on the above substrate to reach a coating thickness of 0.5 μm. Thereafter, in atmosphere, the coating was exposed to ultraviolet radiation employing an ultraviolet radiation exposure apparatus (UV curing apparatus equipped with a conveyer, produced by Iwasaki Electric Co., Ltd.) in an radiation amount which sufficiently cured the coating, whereby a transparent primer layer was formed. The surface of the resultant transparent primer layer was evaluated at 5 positions, employing a non-contact three-dimensional surface shape meter (WYKO NT1100, produced by Veeco Co.), resulting in average surface roughness Ra of 4.3 nm.

Subsequently, each of Transparent Barrier Sheets 3-A - 3-F was prepared in such a manner that Thin Transparent Inorganic Layer A and Thin Transparent Organic Layer B, which are shown in following 3) and 4) were applied on the substrate sheet, on which the above transparent primer layer had been formed, to result in the layer configuration described in Table 3. Thickness of the thin transparent inorganic layer and the thin transparent organic layer, maximum attained temperature and the layer forming period, shown in Table 3, were conditions when each of the thin transparent inorganic layer and the thin transparent organic layer was formed as a single layer, and the layer configuration means that each the above single layers are coated to result in the configuration shown in Table 3. Further, C in Table 3 represents the substrate sheet/transparent primer layer.

3) Preparation of Thin Transparent Inorganic Layer A: While placing a 10 °C cooling plate on the reverse side of a sheet, a thin transparent inorganic layer composed of silicon oxy-nitride was formed employing an ECR plasma deposition apparatus (AFTECH ER-1200, produced by NTT Afty Corp.) in the following manner. Silicon was employed as a solid target. Layer forming conditions were at a microwave power of 500 W, an RF power of 500W, and a layer forming pressure of 0.09 Pa, while gas introduction conditions were at an argon flow rate of 40 sccm and at a gas mixture of nitrogen/oxygen = 8/2 of 0.5 sccm.

Further, the composition ratio of the resulting thin transparent inorganic layer, determined via XPS (X-ray photoelectron spectroscopy) was shown in Table 3.

4) Preparation of Thin Transparent Inorganic Layer B: On the reverse side of a sheet placed was a 10 °C cooling plate and loaded into a vacuum tank. Separately, a thin transparent organic layer forming composition was prepared by completely dissolving 80 parts of 3,4-epoxycyclohexenylmethyl-3',4'-epoxycyclohexane carboxylate, 18 parts of 1,4-butanediol glycidyl ether, and 2 part of diallyliodonium hexafluoroantimonate. After lowering the pressure in the tank to an order of $10^{-4}$ Pa, the resulting composition was fed into an organic deposition source. Subsequently, heating the resistor was initiated, and when impurities were completely vaporized, the deposition shutter was opened, whereby a thin transparent organic layer was deposited. Thereafter, UV at an integral radiation of 500 mJ/cm$^2$ was emitted to form a thin transparent organic layer, whereby a thin transparent organic layer was formed.

Table 3 shows the thickness of the resulting thin transparent inorganic layer and thin transparent organic layer, the deposition time during deposition, and maximum attained temperature T (in K) of the substrate sheet during deposition. Maximum attained temperature during layer formation was determined as follows. A thermo-label was adhered onto the surface of the formed layer and after forming the thin layer, temperature T (in K) was confirmed.

The resulting transparent barrier sheet was evaluated for gas barrier properties and bending resistance, employing the same methods as in Example 1. Table 3 shows the results.

(Preparation of Transparent Barrier Sheet R-3)

A 100 $\mu$m thick cycloolefin film (ZEONOR ZF16, produced by Optes Inc.), as a substrate sheet, was placed in a vacuum tank. After reducing the pressure to an order of $10^{-4}$ Pa, 60 nm thick Thin Transparent Inorganic Layer D composed of silicon oxide was formed via the electron beam deposition method, employing silicon oxide as a target. Thereafter, in the state in which the degree of vacuum was stabilized in an order of $10^{-4}$ Pa, resistor heating was initiated employing an uncured resin composed of one part of a photopolymerization initiator (IRUGACURE 907, produced by Ciba Specialty Chemicals Co.) and 100 parts of bifunctional dicyclopentadienyl diacrylate. When impurities were completely evaporated, the deposition shutter was opened, whereby 500 nm Thin Transparent Organic Layer E was deposited. Further, Thin Transparent Inorganic Layer D and Thin Transparent Organic Layer E were successively formed on Thin Transparent Organic Layer E, whereby comparative Transparent Barrier Sheet R-3 was prepared.

Table 3 shows the thickness of the resulting thin transparent inorganic layer and thin transparent organic layer, the layer forming time during layer formation, and maximum attained temperature T (in K) of the substrate sheet during layer formation. Maximum attained temperature during layer formation was determined as follows. A thermo-label was adhered onto the surface of the formed layer and after forming the thin layer, temperature T (in K) was confirmed.

The resulting transparent barrier sheet was evaluated for gas barrier properties and bending resistance, employing the same methods as in Example 1. Table 3 shows the results.

Table 3

| | | | Inv. 3-A | Inv. 3-B | Inv. 3-C | Inv. 3-D |
|---|---|---|---|---|---|---|
| Transparent Barrier Sheet No. | | | 3-A | 3-B | 3-C | 3-D |
| Glass Transition Temperature of Substrate Sheet Component | | Tg [K] | 436 | 436 | 436 | 436 |
| Thin Transparent Inorganic Layer | Ratio of gas mixture | Nitrogen/ Oxygen | 1.0/0.0 | 0.90/0.10 | 0.85/0.15 | 0.85/0.15 |
| | *2 | Si:O:N | 1:0:1.33 | 1:0.15:1.23 | 1:0.20:1.20 | 1:0.20:1.20 |
| | *1 | [nm] | 60 | 60 | 60 | 60 |
| | *3 | T [K] | 288 | 288 | 288 | 288 |
| | Layer Firming Time | S (seconds) | 720 | 720 | 720 | 720 |
| | | T x S/1000 (K·second) | 207 | 207 | 207 | 207 |
| Thin Transparent Organic Layer | *1 | [nm] | 100 | 100 | 100 | 100 |
| | *3 | T [K] | 288 | 288 | 288 | 288 |
| | Layer Forming Time | S (seconds) | 75 | 75 | 75 | 75 |
| | | T x S/1000 (K·second) | 21.6 | 21.6 | 21.6 | 21.6 |
| Layer Composition | | | C/A/B | C/A/B | C/A/B | C/A/B/A |
| Evaluation of Gas Barrier Properties | Water Vapor Permeability | (g/m$^2$·24hr· 50 °C·90%) | <0.001 | <0.001 | <0.001 | <0.001 |
| | Oxygen Permeability | (ml/m$^2$·24hr· 50 °C·0%) | <0.008 | <0.008 | <0.008 | <0.008 |
| Evaluation of Bending Resistance | Water Vapor Permeability | (g/m$^2$·24hr· 50 °C·90%) | 0.008 | 0.009 | 0.011 | <0.001 |

Inv.: Present Invention, Comp.: Comparative Example, *1: Layer Thickness
*2: Composition of thin inorganic layer, *3: Maximum Attained Temperature

Table 3 (Cont'd)

| | | | Inv. 3-E | Inv. 3-F | Comp. R-3 |
|---|---|---|---|---|---|
| Transparent Barrier Sheet No. | | | 3-E | 3-F | R-3 |
| Glass Transition Temperature of Substrate Sheet Component Tg [K] | | | 436 | 436 | 436 |
| Thin Transparent Inorganic Layer | Ratio of gas mixture | Nitrogen/Oxygen *2 | 0.81/0.19 | 0.75/0.25 | |
| | | Si | 1:0.26:1.16 | 1:0.35:1.10 | 1:2.00:0 |
| | *1 [nm] | | 60 | 60 | 60 |
| | *3 T [K] | | 288 | 288 | 333 |
| | Layer Firming Time | S (seconds) | 720 | 720 | 60 |
| | | T x S/1000 (K·second) | 207 | 207 | 20.0 |
| Thin Transparent Organic Layer | *1 [nm] | | 100 | 100 | 100 |
| | *32 T [K] | | 288 | 288 | 293 |
| | Layer Forming Time | S (seconds) | 75 | 75 | 75 |
| | | T x S/1000 (K·second) | 21.6 | 21.6 | 22.0 |
| Layer Composition | | | C/A/B/A/B | C/A/B/A/B | C/D/E/D/E |
| Evaluation of Gas Barrier Properties | Water Vapor Permeability (g/m²·24hr·50 °C·90%) | | <0.001 | <0.001 | 0.064 |
| | Oxygen Permeability (ml/m²·24hr·50 °C·0%) | | <0.008 | <0.008 | 0.112 |
| Evaluation of Bending Resistance | Water Vapor Permeability (g/m²·24hr·50 °C·90%) | | 0.002 | 0.005 | 0.143 |

Inv.: Present Invention, Comp.: Comparative Example, *13: Layer Thickness
*2: Composition of thin inorganic layer, *3: Maximum Attained Temperature

As can be seen from Table 3, Barrier Sheets 3-A - 3-F of the present invention exhibited the desired gas barrier properties as well as desired bending resistance contrary to Comparative Barrier Sheet R-3.

**Claims**

1.  A transparent barrier sheet comprising:

    a substrate sheet having thereon a transparent primer layer;
    a transparent inorganic thin layer; and
    a transparent organic thin layer,
    wherein:
    the transparent inorganic thin layer comprises silicon nitride or silicon oxy-nitride;
    the transparent organic thin layer is formed by polymerizing a radically polymerizable compound or a cationically polymerizable compound; and
    the transparent primer layer on the substrate has a surface roughness Ra of 5 nm or less.

2.  The transparent barrier sheet of claim 1,
    wherein the cationically polymerizable compound comprises a group selected from the group consisting of an oxirane group, an oxetane group, a tetrahydrofuran group, an oxepane group, a single ring acetal group, a double ring acetal group, an alkenyl ether group, an allene ether group, a ketene acetal group, a lactone group, a cyclic orthoester group or a cyclic carbonate group.

3.  The transparent barrier sheet of claims 1 or 2,
    wherein the transparent inorganic thin layer and the transparent organic thin layer are provided in that order on the transparent primer layer of the substrate sheet.

4.  The transparent barrier sheet of claim 3,
    wherein a second transparent inorganic thin layer is provided on the transparent organic thin layer.

5.  The transparent barrier sheet of claims 1 or 2,
    wherein a second transparent inorganic thin layer; and a second transparent organic thin layer are provided in that order on the transparent organic thin layer, whereby at lease two units each composed of a transparent inorganic thin layer and a transparent organic thin layer are formed on the substrate sheet.

6.  The transparent barrier sheet of any one of claims 1 to 5,
    wherein a thickness of the transparent inorganic thin layer is from 10 to 1000 nm.

7.  A method of producing a transparent barrier sheet comprising the steps of:

    depositing silicon nitride or silicon oxi-nitride on a substrate sheet having thereon a primer layer employing a catalytic chemical vapor deposition method, a reactive plasma deposition method or an electron cyclotron resonance plasma deposition method so as to form a transparent inorganic thin layer; and
    forming a transparent organic thin layer.

8.  The method of producing a transparent barrier sheet of claim 7,
    wherein the transparent organic thin layer is formed by the steps of:

    depositing on the transparent inorganic thin layer vapors of a radically polymerizable compound and a radical polymerization initiator; or a cationically polymerizable compound; and
    polymerizing the deposited vapors by irradiating with actinic rays or by heating.

9.  The method of producing a transparent barrier sheet of claims 7 or 8,
    wherein a maximum attained temperature T (in K) of the substrate sheet is controlled to be in the range of 243 to 383 K during the formations of the transparent inorganic thin layer and the transparent organic thin layer.

10. The method of producing a transparent barrier sheet of claim 9,
    wherein the maximum attained temperature T (in K) of the substrate sheet is controlled to satisfy Formula (1):

Formula (1)

$$1.21 \leq (T \times S)/1000 \leq 460$$

wherein S (in second) represents a required time to form the transparent inorganic thin layer and the transparent organic thin layer.

FIG. 1

FIG. 2

# FIG. 3

352

351

342

341

332

331

322

321

312

311

32

31

## FIG. 4

422

421

412

411

42

42'

411'

412'

421'

422'

## FIG. 5

621

612

611

62

61

FIG. 6

<table>
<tr><td colspan="2">**INTERNATIONAL SEARCH REPORT**</td><td colspan="2">International application No.<br>PCT/JP2007/053905</td></tr>
</table>

**A. CLASSIFICATION OF SUBJECT MATTER**
*B32B9/00*(2006.01)i, *B65D65/40*(2006.01)i, *B65D81/24*(2006.01)i, *C23C14/06*(2006.01)i, *C23C16/42*(2006.01)i

According to International Patent Classification (IPC) or to both national classification and IPC

**B. FIELDS SEARCHED**

Minimum documentation searched (classification system followed by classification symbols)
B32B1/00-43/00, B65D65/40, B65D81/24, C23C14/06, C23C16/42

Documentation searched other than minimum documentation to the extent that such documents are included in the fields searched
Jitsuyo Shinan Koho          1922-1996   Jitsuyo Shinan Toroku Koho   1996-2007
Kokai Jitsuyo Shinan Koho    1971-2007   Toroku Jitsuyo Shinan Koho   1994-2007

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2005-125731 A (Fuji Photo Film Co., Ltd.), 19 May, 2005 (19.05.05), Claims; Par. Nos. [0059], [0067] to [0103], [0105], [0108], [0113], [0125] & US 2005/79380 A1 | 1-10 |
| Y | JP 2005-251500 A (Fuji Photo Film Co., Ltd.), 15 September, 2005 (15.09.05), Claims; Par. Nos. [0013], [0014], [0055], [0063] to [0097], [0103] (Family: none) | 1-10 |
| Y | JP 2001-310412 A (Mitsui Chemicals, Inc.), 06 November, 2001 (06.11.01), Par. No. [0012] (Family: none) | 1-6 |

[X] Further documents are listed in the continuation of Box C.    [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
11 May, 2007 (11.05.07)

Date of mailing of the international search report
22 May, 2007 (22.05.07)

Name and mailing address of the ISA/
Japanese Patent Office

Authorized officer

Facsimile No.

Telephone No.

Form PCT/ISA/210 (second sheet) (April 2005)

| | **INTERNATIONAL SEARCH REPORT** | International application No. |
|---|---|---|
| | | PCT/JP2007/053905 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-89165 A (Dainippon Printing Co., Ltd.), 25 March, 2003 (25.03.03), Par. Nos. [0018], [0019] (Family: none) | 1-6 |
| Y | JP 2005-107359 A (Konica Minolta Medical & Graphic, Inc.), 21 April, 2005 (21.04.05), Par. No. [0023] (Family: none) | 2 |
| Y | JP 2005-342975 A (Toppan Printing Co., Ltd.), 15 December, 2005 (15.12.05), Par. No. [0014] (Family: none) | 7-10 |
| Y | JP 2004-255706 A (Teijin Dupont Film Kabushiki Kaisha), 16 September, 2004 (16.09.04), Par. Nos. [0060], [0061] (Family: none) | 7-10 |
| Y | JP 2004-160836 A (Mitsui Chemicals, Inc.), 10 June, 2004 (10.06.04), Par. No. [0060] (Family: none) | 9,10 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003276115 A
- JP 2003300273 A
- JP 10507705 A
- JP 2005035204 A
- JP 91040852000 A
- JP 122005 A
- JP 2000216049 A
- JP 2003172935 A
- JP 2003233076 A
- JP 2003322859 A
- JP 2004001296 A
- JP 2004359899 A
- JP 2004103401 A
- JP 8512256 PCT
- JP 11503195 PCT
- JP 2001508089 PCT
- JP 2001518561 PCT
- JP 2002528568 PCT
- JP 2004532330 PCT
- JP 2004533313 PCT
- JP 2005524058 PCT
- JP 5170763 A
- JP 5371224 A
- JP 6016804 A
- JP 7017958 A
- JP 7173279 A
- JP 8245783 A
- JP 8301859 A
- JP 10237056 A
- JP 10330485 A
- JP 11106380 A
- JP 11130766 A
- JP 11228558 A
- JP 11246510 A
- JP 11246540 A
- JP 11246541 A
- JP 11322735 A
- JP 2000001482 A
- JP 2000026546 A
- JP 2000191652 A
- JP 2000302774 A
- JP 2000336133 A
- JP 2001031664 A
- JP 2001031665 A
- JP 2001031666 A
- JP 2001040085 A
- JP 2003081958 A
- JP 2003089693 A
- JP 2001163882 A

- JP 2001226365 A
- JP 2001278874 A
- JP 2001278875 A
- JP 2001302651 A
- JP 2001342194 A
- JP 2002020376 A
- JP 2002080581 A
- JP 2002193965 A
- JP 2002241489 A
- JP 2002275171 A
- JP 2002275172 A
- JP 2002322268 A
- JP 2003002881 A
- JP 2003012662 A
- JP 2004091347 A
- JP 2004149486 A
- JP 2004262817 A
- JP 2005125731 A
- JP 2005171122 A
- JP 2005238446 A
- JP 2005239573 A
- JP 2005336349 A
- JP 11500422 PCT
- JP 2003341003 A
- JP 2004341016 A
- JP 2306247 A
- JP 62057646 A
- JP 5107999 A
- JP 5181271 A
- JP 8016080 A
- JP 8305262 A
- JP 2000047552 A
- JP 2003066816 A
- US 5759721 A
- EP 1029258 A
- JP 58037003 A
- JP 63223002 A
- JP 56152838 A
- JP 63008365 A
- JP 63008366 A
- JP 1083060 A
- JP 1290658 A
- JP 2001470 A
- JP 2196812 A
- JP 2232253 A
- JP 3017101 A
- JP 3047164 A
- JP 3048654 A
- JP 3145459 A

- JP 3200761 A
- JP 3237107 A
- JP 4001177 A
- JP 4210673 A
- JP 8188569 A
- JP 8188570 A
- JP 11029609 A
- JP 11255739 A
- JP 2001055374 A
- JP 2002069644 A
- JP 2002069646 A
- JP 2002299259 A
- JP 2004211160 A
- JP 2004217966 A
- JP 2004292877 A
- JP 2004315899 A
- JP 2005179693 A
- JP 2001262323 A
- JP 2001295031 A
- JP 2001348660 A
- JP 2001348662 A
- JP 2002030426 A
- JP 2002053950 A
- JP 2002060929 A
- JP 2002115049 A
- JP 2002180240 A
- JP 2002217131 A
- JP 2002249871 A
- JP 2003105526 A
- JP 2004076025 A
- JP 2005034831 A
- JP 3197682 A
- JP 4216628 A
- JP 4257224 A
- JP 4311036 A
- JP 5070955 A
- JP 5090247 A
- JP 5009742 A
- JP 5117867 A
- JP 5129281 A
- JP 5171435 A
- JP 6244175 A
- JP 6280000 A
- JP 7263359 A
- JP 7335575 A
- JP 8078333 A
- JP 9017598 A
- JP 2003129236 A
- JP 2003303698 A
- JP 2005307222 A
- JP 5125520 A
- JP 6316757 A
- JP 7026023 A
- JP 9104085 A
- JP 9272703 A
- JP 9031115 A
- JP 10092800 A
- JP 10168559 A
- JP 10289902 A
- JP 11172418 A
- JP 2000087224 A
- JP 2000122005 A
- JP 2000127186 A
- JP 2000348971 A
- JP 2003003250 A
- JP 2003335880 A
- JP 2005014483 A
- JP 2005178010 A
- JP 8503099 PCT
- JP 2004524958 PCT

**Non-patent literature cited in the description**

- Imaging yo Yuuki Zairyo. Bunshin Shuppan, 1993, 187-192
- **TATSUO ASAGI.** *Hakumaku Sakusei no Kiso,* March 1996, 152-154226